# EUROPÄISCHE PATENTANMELDUNG

(11) **EP 2 295 819 A2**
(43) Veröffentlichungstag der Anmeldung: **16.03.2011**
(21) Anmeldenummer: 10171899.7
(22) Anmeldetag: 04.08.2010
(51) Int. Cl.: F04D 29/52, H05K 7/20

(54) **Integriertes Lüfterreglermodul und Verfahren zur Herstellung eines integrierten Lüfterreglermoduls**

(30) Priorität: 21.08.2009 DE 102009038301
(71) Anmelder: Behr GmbH & Co. KG, 70469 Stuttgart (DE)
(72) Erfinder: Aschermann, Uwe, 76199 Karlsruhe (DE); Bielesch, Thomas, 75417 Mühlacker (DE); Schweizer, Benjamin, 75173 Pforzheim (DE)
(74) Vertreter: Grauel, Andreas

(57) **Zusammenfassung**

Die vorliegende Erfindung betrifft ein integriertes Lüiterreglermodul (2), das eine Abdeckplatte (1) für einen Lüfter eines Fahrzeugs umfasst, wobei ein in der Ebene der Abdeckplatte (1) liegende- Verschlussfiächen-Teilbereich der Abdeckplatte (1) als Verschlusstläche für einen Gehäusedeckel (8) ausgestaltet ist und am Rand des Verschlussflächen-Teilbereich zumindest eine Befestigungseinheit (6) für den Gehäusedeckel (8) einer Reglreinheit (12) vorgesehen ist. Weiterhin umfasst das integrierte Lüfterreglermodul (2) einen Gehäusedeckel (8), der an der zumindest einen Befestigi-ngseinhelt (6) der Abdeckplatte (1) befestigt ist, so dass der Versclussflächen-Teilbereich der Abdeckplatte (1) und der Gehäusedeckel (8) ein umschließendes Gehäuse für die Reglereinheit (12) bilden.

## Beschreibung

Die vorliegende Erfindung bezieht sich auf ein integriertes Lüfterreglermodul gemäß Anspruch 1 sowie ein Verfahren zur Herstellung eines integrierten Lüfterreglermoduls gemäß, Anspruch 14.

Herkömmliche Verbrennungsmotoren verursachen beim Betrieb eine erhebliche Wärme, die zur Vermeidung einer Überhitzung des Motors abgeführt werden sollte. Hierzu wird oftmals ein Wasserkühler verwendet, der weiterhin eine Wärmeabgabeeinhelt aufweist, die durch einen elektrischen Lüfter in Form eines Gebläses mit Luft gekühlt wird. Dieser Lüfter hat eine Reglereinheit, die den Lüfter je nach Bedarf ein- oder ausschaltet, um eine zusätzliche Kühlung der Wärmeabgabeeinheit zu ermöglichten, wenn der Motor stark belastet ist und daher viel Wärme erzeugt.

Um eine kompakte Baueinheit zu erreichen, wird bisher das Reglermodul für ein solches Motorkühlungsgebläse als komplette Einheit auf einer Lüfterzarge montiert. Dabei wird das Reglermodul als eigene Einheit erstellt und dann in einen separaten Arbeitsschritt an der Zarge befestigt. Eine solche Vorgehensweise ist jedoch nachteilhaft, da hierzu ein separater Arbeitsschritt des Befestigens des Reglermoduls an der Zarge erforderlich ist. Ein solcher separater, d.h. zusätzlicher Arbeitsschritt erfordert folglich einen erhöhten Arbeitssaufwand und somit erhöhte Herstellungskosten für die Herstellung des Lüfterreglermoduls.

Die DE 199 29 194 A1 zeigt einen Anschlusskasten für eine Schaltung, der integral mit einer Lüfterverkieidung ausgebildet sein kann. Allerdings ist bei dem in der DE 199 29 194 A1 dargestellten Anschlusskasten immer ein spezieller Vorsprung in der Lüfterverkleidung zur Aufnahme der Reglerschaltung notwendig, der eine Montage des Gehäuses einerseits erschwert und ferner einen erhöhten Materialaufwand für das Ausbilden dieses Anschlusskastens in der Lüfterverkleidung erfordert.

Es ist daher die Aufgabe der vorliegenden Erfindung, ein Lüfterreglermodul sowie ein Verfahren zur Herstellung eines Lüfterreglermoduls mit verbesserten Eigenschaften zu schaffen.

Diese Aufgabe wird durch ein integriertes Lüfterreglermodul gemäß Anspruch 1 sowie ein Verfahren zur Herstellung eines integrierten Lüfteneglermoduls gemäß Anspruch 14 gelöst.

Die vorliegende Erfindung schafft ein integriertes Lüfterreglermodul, das folgende Merkmale aufweist:
- eine Abdeckplatte für einen Lüfter eines Fahrzeugs, wobei ein in der Ebene der Abdeckplatte liegender Verschlussflächen-Teilbereich der Abdeckplatte als Verschiussfläche für ein Gehäuse ausgestaltet ist und am Rand des Verschlussflächen-Teilbereichs zumindest eine Befestigungseinheit für einen Gehäusedeckel einer Reglereinheit vorgesehen ist; und
- den Gehäusedeckel, der an der zumindest einen Befestigungseinheit der Abdeckplatte befestigt ist, so dass der Verschlussflächen-Teilbereicn der Abdeckplatte und der Gehäusedeckel ein die Reglereinheit umschließendes Gehäuse bilden.

Ferner schafft die vorliegende Erfindung ein Verfahren zur Herstellung eines integrierten Lüfterreglermoduls, wobei das Verfahren die folgenden Schritte umfasst:
- Bereitstellen einer Abdeckplatte für einen Lüfter eines Fahrzeugs, wobei ein in der Ebene der Abdeckplatte liegender Verschlussflächen-Teilbereich der Abdeckplatte als Verschlussfläche für einen Gehäusedeckel ausgestaltet ist und am Rand des Verschlussflächen-Teilbereichs zumindest eine Befestigungseinheit für einen Gehäusedeckel einer Reglereinheit vorgesehen ist;
- Bereitstellen eines Gehäusedeckels, der an der zumindest einen Befestigungseinheit der Abdeckplatte befestigbar ist; und
- Aufsetzen des Gehäusedeckels auf den Verschlussflächen-Teilbeich der Abdeckplatte und Befestigen des Gehäusedeckels an dem Verschlussflächen-Teilbereich unter Verwendung der Befestigungseinheit, um ein die Reglereinheit umschließendes Gehäuse zu bilden.

Die vorliegende Erfindung basiert auf der Erkenntnis, das nun ein Teil der Abdeckplatte zugleich als Teil des Gehäuses um die Reglereinheit verwendet werden kann. Hierzu wird ein Teilbereich der Abdeckplatte (das heißt ein Verschlussflächen-Teilbereich) vorgesehen, an dem ein Gehäusedeckel über die Befestigungseinheit an der Abdeckplatte befestigt werden kann. Auf diese Weise wird ein Gehäuse um die Reglereinheit ausgebildet, wobei die Reglereinheit vor dem Verschließen des Gehäuses beispielsweise im Gehäusedeckel platziert werden kann. Die Befestigungseinheit, die beispielsweise ein Aufnahmeschlitz für einen Bajonettverschiuss sein kann, ermöglicht die schnelle und technisch sehr einfach durchzuführen der Befestigung des Gehäusedeckel es an der Abdeckplatte im Verschlussflächen-Teilbereich.

Die vorliegende Erfindung bietet den Vorteil, dass nun sehr einfach ein Gehäuse für die Reglereinheit geschaffen werden kann, wobei zur Vermeidung von einem erhöhten Materialaufwand ein Teil der Abdeckplatte zugleich als Gehäuseteil nutzbar ist. Das Befestigen des Gehäusedeckels erfordert keinen großen Fertigungsauf von und lässt sich somit sehr kostengünstig durchführen.

In einer günstigen Ausführungsform der vorliegenden Erfindung kann der Verschlussflächen-Teilbereich eine runde Form aufweisen und der Gehäusedeckel ebenfalls eine runde Form aufweisen, so dass das gebadete Gehäuse die Form eines Zylinders hat. Eine derartige Ausführungsform der vorliegende Erfindung bietet den Vorteil, dass eine Montage des Gehäusedeckel sehr einfach ausgeführt werden kann, beispielsweise durch ein Aufschrauben des Gehäusedeckels an der Befestigungseinheit oder sein Einrasten einer Nase des Gehäusedeckels gegen die Befestigungseinheit nach Art eines Bajonettverschlusses. Eine eckige Form des Gehäuses würde sich nicht derart leicht montieren lassen, wie die hier vorgeschlagene runde oder zylindrische Form des Gehäuses

Um eine sehr einfache Platzierung des Gehäusedeckels in Bezug zur Abdeckplatte zu ermöglichen, kann auch der Verschlussflächen-Teilbereich eine Aufnahmenut zur Aufnahme einer Wand des Gehäusedeckels aufweisen.

Ferner kann auch in einer weiteren Ausführungsform der vorliegenden Erfindung der Gehäusedeckel einen Vorsprung aufweisen, der ausgebildet ist, um mit der Befestigungseinheit als ein Bajonett-Verschluss zusammenzuwirken. Eine derartige Ausführungsform der vorliegenden Erfindung bietet den Vorteil, dass eine Montage des Gehäusedeckels auf die Abdeckplatte und die Befestigung an der Befestigungseinheit sehr einfach und somit kostengünstig technisch realisierbar ist. Das Vorsehen des Vorsprungs kann einfach umgesetzt werden.

Günstig ist es auch, wenn der Gehäusedeckel einen Kühlkörper aufweist, der in den Gehäusedeckel eingegossen oder eingespritzt ist. Eine derartige Ausführungsform der vorliegenden Erfindung bietet den Vorteil, dass einerseits der Kühlkörper an einer fest definierten Position platziert werden kann und auch dort beim Befestigen des Gehäusedeckels verbleibt und zweitens durch das Befestigen des Gehäusedeckels ein ausreichend großer Druck von Kühlkörper auf die entsprechenden zu kühlenden Leistungshalbleiterbauelernente ausgeübt werden kann. Zugleich ermöglicht das Eingießen oder Einspritzen eine Reduktion des Platzbedarfs für den Kühlkörper und ermöglicht die einfache Durchleitung von Wärme durch eine Wand des Gehäuses.

Um eine gute Ankopplung der zu kühlenden Bauelemente in dem Gehäuse zu ermöglichen, kann auch der Gehäusedeckel in einem Bereich einen freiliegenden Teil des Kühlkörpers aufweisen, der zur thermischen Kontaktierung von zumindest einem Bauelement der Reglerschaltung ausgebildet ist.

Um eine unaufwändige elektrische Verbindung der Reglereinheit von außerhalb des Gehäuses zu ermöglichen, kann der Gehäusedeckel Kontaktanschlüsse zur Kontaktierung der Reglereinheit von außerhalb des Gehäuses aufweisen, die den Gehäusedeckel eingegossen oder eingespritzt sind. Eine derartige Ausführungsform der vorliegenden Erfindung bietet ebenfalls den Vorteil, dass durch das Einspritzen oder Eingießen der Kontaktanschiüsse in das Material des Gehäuses oder des Gehäusedeckels die elektrische Kontaktierung der Reglereinheit technisch einfach möglich ist. Auf diese Weise kann darauf verzichtet werden, die Kontaktierung durch ein zu fertigendes Loch im Gehäuse oder im Gehäusedeckel führen zu müssen, was deutlich arbeitsintensiver und daher kostenintensiver wäre.

Ferner können auch gemäß einer anderen Ausführungsform der Erfindung die Kontaktanschiüsse des Gehäusedeckels in den Innenbereich hineinragen und frei zugänglich sein, so dass eine Kontaktierung von freiliegenden Anschlusskontakten einer Reglerschaltung durch nicht-storfschlüssiges Verbinden, insbesondere Anpressen der Anschiusskontakte an die Kontaktanschlüsse durchführbar ist. Eine derartige Ausführungsform der vorliegenden Erfindung bietet den Vorteil, das die Anschjusskontakte der Reglereinheit schnell und technisch einfach von außerhalb des Gehäuses kontaktiert werden können. Auf diese Weise kann auch beispielsweise ein Schritt des Verlötens der Kontaktanschlüsse mit den Anschlusskontakten der Reglereinheit vermieden werden, was sonst einen zusätzlichen unter somit kostentreibenden weiteren Arbeitsschritt bedeuten würde.

Für eine schnelle und zuverlässige Kontaktierung der Reglereinheit, beispielsweise durch standardisierte Steckkontakte im Fahrzeug, kann auch der Gehäusedeckel einen Stecker zur Aufnahme von Steckkontakten aufweisen, wobei der Stecker einstückig mit dem Material des Gehäusedeckels gefertigt ist. Eine derartige Ausführungsform der vorliegenden Erfindung bietet den Vorteil, dass der Stecker bereits bei der Herstellung des Gehäusedeckels angebracht oder angespritzt werden kann, so dass ein zusätzlicher Arbeitsschritt des separaten Befestigens des Steckers am Gehäuse oder am Gehäusedeckel vermieden wird.

Auch kann in einer anderen Ausführungsform der vorliegenden Erfindung die Abdeckplatte im Verschlussflächen-Teilbereich einen Kühlkörper aufweisen, wobei der Kühlkörper in die Abdeckplatte eingegossen oder eingespritzt ist. Eine derartige Ausführungsform der vorliegenden Erfindung bietet ähnliche Vorteile wie das Vorsehen des Kühlkörpers im Gehäusedeckel. Jedoch kann alternativ oder zusätzlich zum Kühlkörper im Gehäusedeckel dieser Kühlkörper auch in der Abdeckplatte integriert sein wodurch eine hohe Wärmeabfuhr direkt durch die Abdeckplatte in den Lüfter möglich wird. Der Lüfter bewirkt dann eine aktive Kühlung eines Teils des Kühlkörpers, wodurch sich eine hohe Kühlleistung erzielen lässt.

In einer anderen Ausführungsform der vorliegenden Erfindung kann auch die Abdeckplatte im Verschlussflächen-Teilbereich eine Wand aufweisen, die von der Abdeckplatte absteht, wobei die Wand ausgebildet ist, um den Gehäusedeckel aufzunehmen und zusammen mit dem Gehäusedeckel das die Reglereinheft umschließende Gehäuse zu bilden. Eine derartige Ausführungsform der vorliegenden Erfindung bietet den Vorteil eines erhöhten Schutzes der Reglereinheit gegen Flüssigkeiten, da die Verbindung zwischen der Wand und der Abdeckplatte als einstückige Verbindung in hohem Maße, fluidundurchlässig ist.

Ferner kann auch die Abdeckplatte im Verschlussflächen-Teilbereich Steckkontakte aufweisen die ausgebildet sind, um eine Kontaktierung von Anschlusskontakten der Reglereinheit von außerhalb des Gehäuses zu ermöglichen, wobei die Steckkontakte in das Material der Abdeckplatte eingegossen oder eingespritzt sind. Eine derartige Ausführungsform der vorliegenden Erfindung bietet den Vorteil einer sehr einfach zu realisierenden Kontaktmöglichkeit der Reglereinheit von außerhalb des Gehäuses.

Insbesondere dann, wenn die Abdeckplatte und/oder der Gehäusedeckel aus einem Kunststoffmaterial hergestellt sind, können die Einbettungen der genannten Steckkontakte oder der Kühlkörper gut umgesetzt werden, wobei durch die Eigenschaften des Kunststoffmaterials meist auch eine ausreichende elektrische isolierung der einzelnen Kontakte sichergestellt werden kann.

Vorteilhafte Ausführungsbeispiele der vorliegenden Erfindung werden nachfolgend Bezug nehmend auf die beiliegenden Zeichnungen näher erläutert. Es zeigen:
- Fig. 1: eine Darstellung eines Ausführungsbeispiels der vorliegenden Erfin- dung, bei der eine Lüfterzarge mit einem Reglermodul wiedergegeben ist;
- Fig. 2: eine weitere Darstellung des in Fig. 1 dargestellten Ausführungsbei- spieles in vergrößerter Ansicht;
- Fig. 3: eine Darstellung eines zargenseitigen Gehäuseteils auf der Lüfterzarge mit Bajonett-Verschluss;
- Fig. 4: eine Darstellung eines oberen Gehäuseteils mit eingespritztem Kühl- körper und eingespritztem Anschlüssen;
- Fig. 5: eine weitere Darstellung eines oberen Gehäusedeckels mit eingespritz- tem Kühlkörper und Anschlüssen;
- Fig. 8: eine Darstellung des oberen Gehäusedeckels mit an- oder eingespritzt- tem Steckergehäuse;

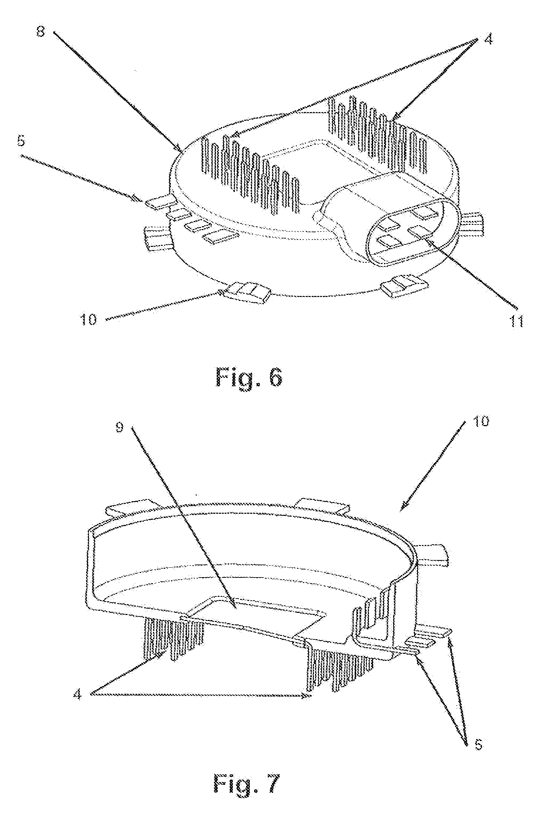

- Fig. 7: eine Schnittdarstellung durch den oberen Gehäusedeckel mit Kühlkör- per und Anschlüssen:

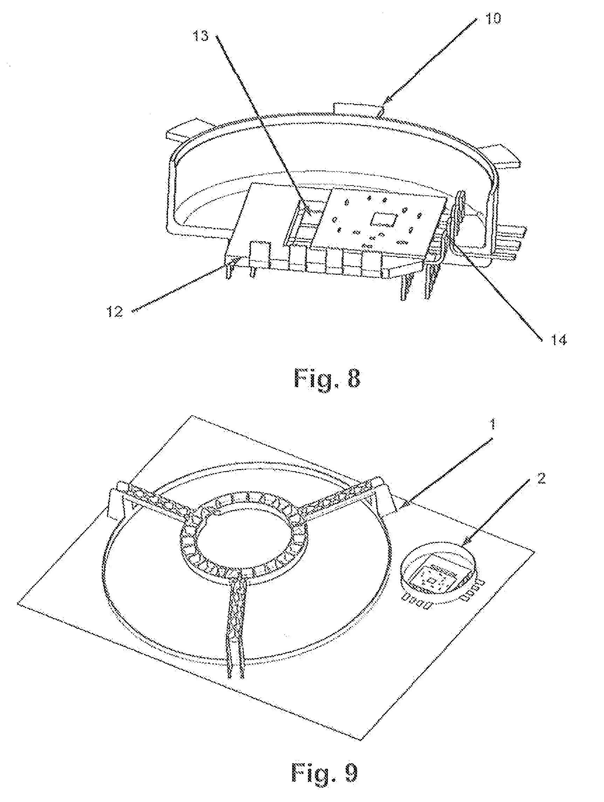

- Fig. 8: eine Schnittdarstellung durch das obere Gehäuseteil mit einer im Ge- häuseteil angeordneten Elektronik;
- Fig. 9: eine Darstellung einer Lüfterzarge mit Reglermodul auf der Zarge;

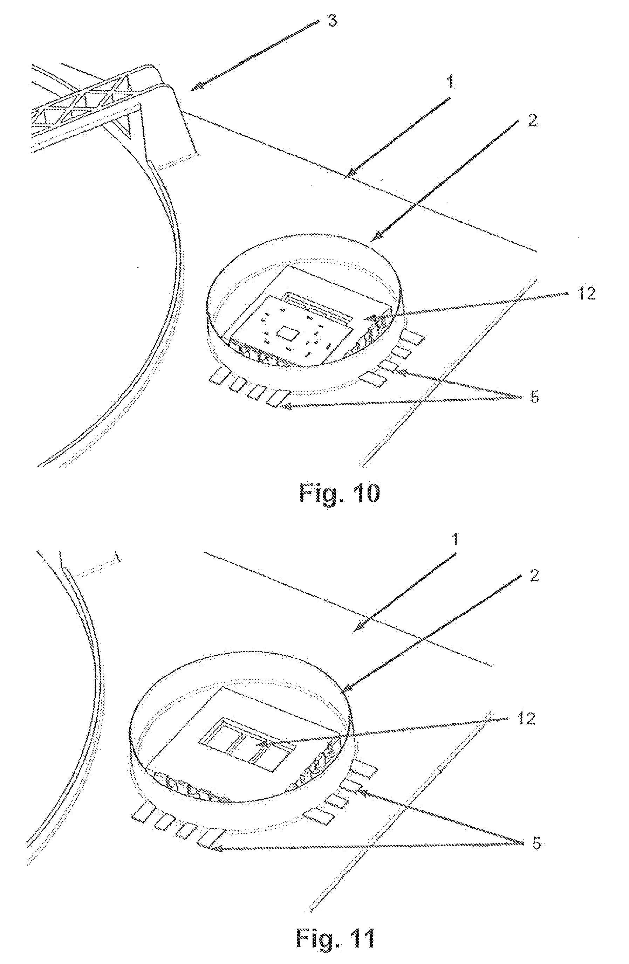

- Fig. 10: eine weitem Darstellung eines Ausführungsbeispiels der vorliegenden Erfindung mit einem Reglermodul auf der Zarge;
- Fig. 11: eine Darstellung eines in die Zarge eingespritzten kühlkörpers;

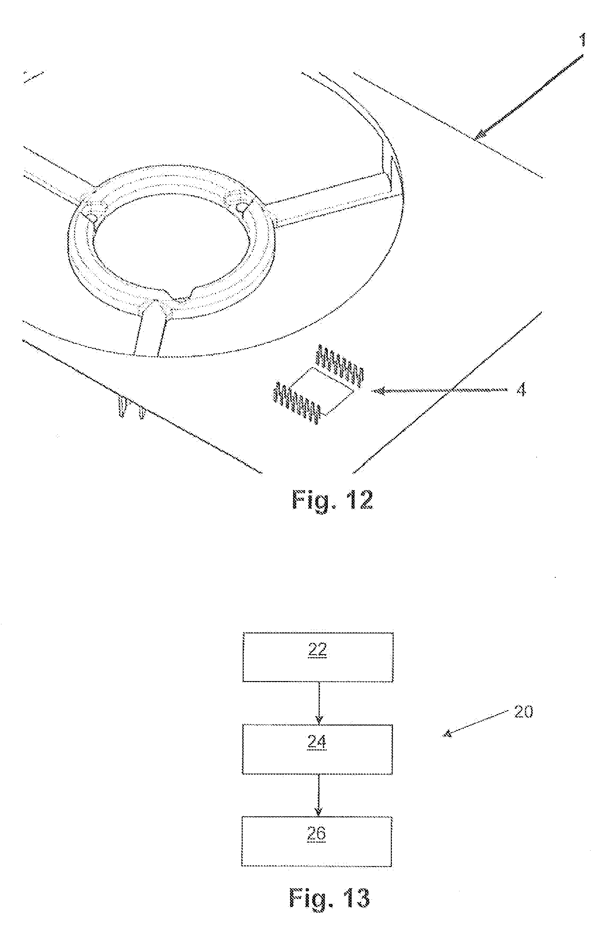

- Fig. 12: eine Darstellung einer empfohlenen Ausführungsform des Kühlkörpers als Stanzteil; und
- Fig. 13: ein Ablaufdiagramm eines Ausführungsbeispiels der vorliegenden Er- findung als Verfahren.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird. Die beschriebenen Auführungsbeispieie sind nur beispielhaft gewählt und können miteinander kombiniert werden.

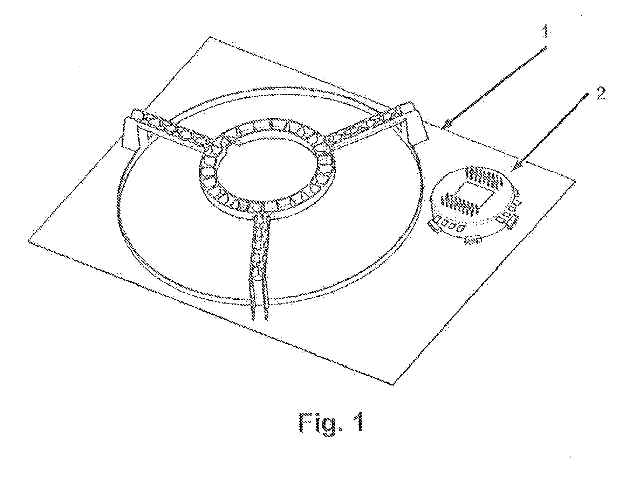

Fig. 1 zeigt eine Darstellung eines Ausführungsbeispiels der vorliegenden Erfindung, bei der eine Lüfterzarge 1 mit einem Reglermodul 2 wiedergegeben ist. Das Reglermodul 2 ist derart in die Lüfterzarge 1 integriert, dass ein Teilbereich der Lüfterzarge 1 einen Teil des Gehäuses um das Reglermodul 2 bildet Die Lüfterzarge 1 kann beispielsweise eine große Öffnung ausweisen, die einen Lufteinlass oder einen Luftauslass für den Lüfter bildet. Beispielsweise kann der Teilbereich der Lüfterzarge 1, der unter dem in Figur 1 dargestellten Gehäuse für das Reglermodul 2 liegt, den bodenseitigen Verschluss des Gehäuses für das Reglermodul 2 bilden.

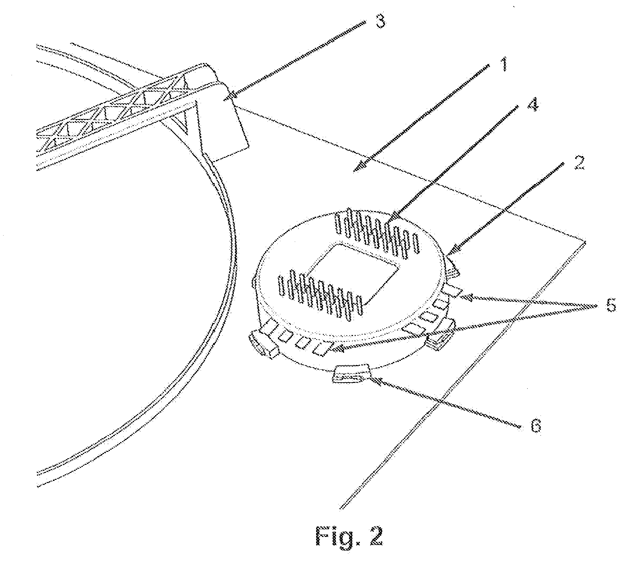

Fig. 2 zeigt eine Darstellung des in Figur 1 dargestellten Ausführungsbeispiels in vergrößerter Ansicht. Dabei wird erkennbar, dass die Lüfterzarge 1 im Bereich des Luftein- beziehungsweise Luftauslasses eine Motorhaltestrebe 3 aufweist, an der beispielsweise ein Lüftermotor befestigt werden kann. Das Reglermodul 2 weist im oberen Gehäusedeckel einen eingegossenen Kühlkörper 4 und eingegossene Anschlüsse 5 auf, über weiche Wärme von Komponenten der Reglerschaltung abgeführt werden kann oder die Reglerschaltung im Inneren des Gehäuses des Reglermoduls 2 mit elektrischer Energie versorgt werden kann und über welche auch Steuersignale zwischen der Reglerschaltung und externen Sensoren oder Aktoren ausgetauscht werden kannen. Ferner sind an der Lüfterzarge 1 Bajonettbefestigungen 6 als Befestigungseinheiten vorgesehen, über welche das obere Gehäuseteil (im Weiteren auch synonym als Gehäusedeckel bezeichnet) an der Lüfterzarge 1 befestigt werden kann.

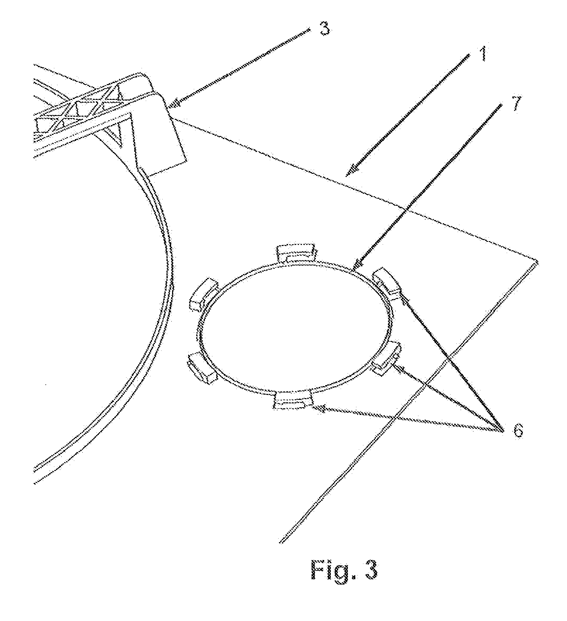

Fig. 3 zeigt eine Darstellung eines zargenseitigen Gehäuseteils auf der Lüfterzarge 1 mit Bajonett-Verschluss. In Figur 3 ist dabei eine Darstellung mit abgenommenem Gehäusedeckel wiedergegeben. Um denjenigen Bereich der Lüfterzarge 1, der als Verschlussflächen-Teilbereich zusammen mit dem Gehäusedeckel das Gehäuse um das Reglermodul bilden soll, ist eine Zentrierung 7, beispielsweise in Form einer Nut, vorgesehen, die weiterhin mit einer Dichtung versehen sein kann. Über diese Zentrierung 7 mit der Dichtung kann einerseits der Gehäusedeckel sehr einfach und sicher auf die Lüfterzarge 1 aufgesetzt und über die Befestigungseinheiten 6 befestigt werden, wobei die Dichtung einen sicheren Schutz der Reglerschaltung im inneren des Reglermoduls 2 gegen Fluide bietet. Die Befestigungseinheiten 6 in Form der Bajonettbefestigung sind dabei kreisförmig an einem äußeren Randbereich der Zentrierung 7 an der Lüfterzarge 1 angeordnet.

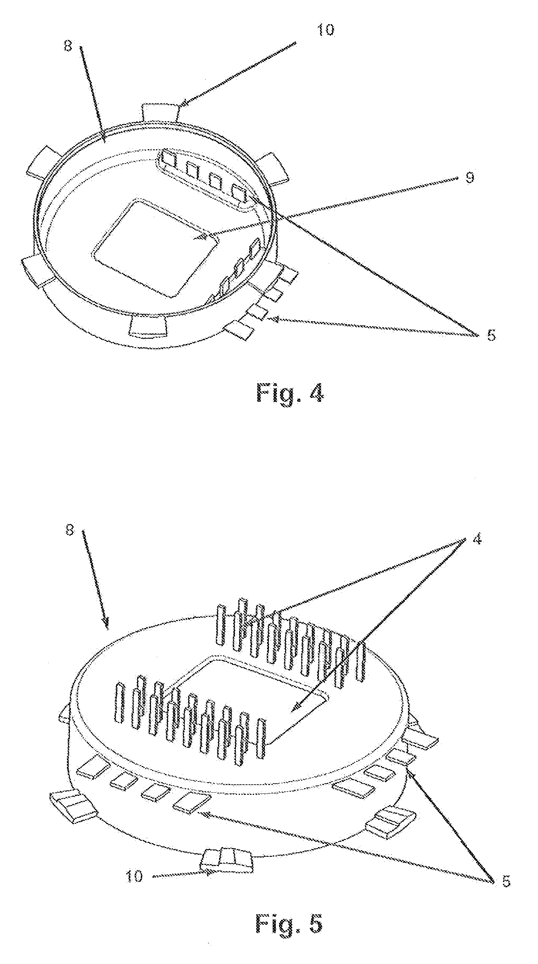

Fig. 4 zeigt eine Darstellung eines oberen Gehäuseteils (d.h. dem Gehäusedeckel 8) mit eingespritztem Kühlkörper 4 und eingespritztem Anschlüssen 5. Dabei ist der Gehäusedeckel 8 in einer Ansicht von unten dargestellt, so dass in das Innere des Gehäusedeckels 8 gesehen werden kann. Hierbei wird ersichtlich, dass in der Wand des Gehäusedeckels 8 ein Bereich 9 des eingespritzten Kühlkörpers 4 freiliegt, um eine gute thermische Anbindung von Leistungselektronikkomponenten der Reglerschaltung an den Kühlkörper 4 zu ermöglichen. Dadurch wird eine gute Wärmeabfuhr von elektronischen Bauteilen über den in den Gehäusedeckel 8 eingespritzten Kühlkörper 4 erreicht. Weiterhin wird aus Fig. 4 ersichtlich, dass die in den Gehäusedeckel 8 eingespritzten Anschlüsse 5 L-förmig sind und somit die in das Inner des Gehäusedeckels 8 hineinragenden Enden dieser Anschlüsse 5 in Richtung der Öffnung des Gehäusedeckels 8 (d.h. im zusammengebauten Zustand in Richtung des Verschiussfiächen-Teilbereichs der Lüfterzarge 1) ausgerichtet sind. Dies ermöglicht eine sehr einfache Kontaktierung der Reglerschaltung, wie nachstehend noch näher erläutet wird. Ferner sind in Fig. 4 Laschen oder Vorsprünge 10 erkennbar, die vom Rand des Gehäusedeckels 8 abstehen und die zur Verriegelung in den Befestigungselementen 6 (d.h. dem Bajonett-Befestigungselementen) auf der Lüfterzarge 1 gemäß Fig. 3 vorgesehen sind.

Fig. 5 zeigt eine weitere Darstellung der eines Gehäusedeckels 8 mit eingespritztem Kühlkörper 4 und Anschlüssen 5, diesmal in einer Ansicht von oben. Deutlich sichtbar sind die Kühlrippen des Kühlkörpers 4, die von einem oberen Deckelbereichdes Gehäusedeckels 8 abstehen. Weiterhin sind auch die in den Gehäusedeckel 8 eingespritzten Anschlüsse 5 deutlich ersichtlich, die seitlich im oberen Deckelbereich aus dem Gehäusedeckel 8 herausragen. Auch sind die Laschen 10 für die Bajonettbefestigung in Fig.5 gut erkennbar, die zur sicheren Verriegelung eine Einrastnase aufweisen, die ein unbeabsichtigtes Lösen der Verbindung zwischen dem Gehäusedeckel 8 und den Befestigungseinheiten 6 auf der Lüfterzarge 1 nach der Montage verhindern.

Fig. 6 zeigt eine Darstellung eines weiteren Ausführungsbeispiels der vorliegenden Erfindung, bei der zusätzlich zu der Ausführung gemäß den Figuren 4 und 5 am Gehäusedeckel 8 (d.h. dem oberen Gehäuseteil) ein angespritztes Steckergehäuse vorgesehen ist. Bei einem solchen Ausführungsbeispiel des Gehäusedeckels 8 können die in den Gehäusedeckel 8 eingespritzten Anschlüsse 5 zumindest teilweise durch das Steckergehäuse 11 umgeben sein, das beispielsweise eine Form aufweist, die durch eine entsprechende Buchse in Gegenform ein fehlerhaftes Kontaktieren der Anschlüsse 5 verhindert. Das Herstellen des Steckergehäuses 11 zusammen mit dem Gehäusedeckel 8 bietet den Vorteil einer integrierten und einer sehr einfachen Herstellung wobei ein zusätzlicher Arbeitsschritt vermieden werden kann, indem das Steckergehäuse 11 an den Gehäusedeckel 8 befestigt wird.

Fig. 7 zeigt eine Schnittdarstellung durch den oberen Gehäusedeckel 8 mit Kühlkörper 4 und Anschlüssen 5. Aus der Darstellung gemäß. Fig. 7 ist dabei ersichtlich, wie der Kühlkörper 4 in das Material des oberen Gehäusedeckelbodens eingebettet und im Mittelbereich 9 frei Zugänglich ist, um eine möglichst gute thermische Ankopplung an die wärmeproduzierenden Halbleiterbauelemente zu ermöglichen. Zugleich ist die L-Form der in das Material des Gehäusedeckels 8 eingespritzten Anschlüsse 5 gut erkennbar, die seitlich aus dem Gehäusedeckel 8 herausstehen und in Bodenbereich des Gehäusedeckels 8 in Richtung der Öffnung des Gehäusedeckels 8 abgewinkelt sind.

Fig. 8 zeigt eine Schnittdarstellung durch das obere Gehäuseteil 8, in den eine (Regler-) Elektronik (oder Reglerschaltung) 12 eingebettet ist. Die Elektronik 12 kann dabei Leistungselektronik-Halbleiterbauelemente mit einem Stanzgitter umfassen. Die Leistungselektronik 12 kann ferner Transistoren 13 aufweisen, die bei der Montage thermisch mit dem freiliegenden Mittelbereich 9 des Kühlkörpers 4 (entsprechend den Figuren 4 bis 7) verbunden werden. Weiterhin sind in Fig. 8 die Laschen 10 für die Bajonettbefestigung des Gehäusedeckels 8 an dein Befestigungseiementen 6 zu erkennen. Aus Fig. 8 wird ferner die sehr einfach herzustellende Verbindung 14 zwischen dem Stanzgitter und den Anschlüssen 5 im Inneren des Gehäusedeckels 8 ersichtlich. Es ist zu erkennen, dass die L-Form der Anschlüsse 5 im inneren des Gehäusedeckels 8 eine sehr einfache Kontaktierung mit den Anschlusskontakten der Regelelektronikschaltung 12 ermöglicht, die ebenfalls in einer L-Form ausgestaltet sein können. Hierdurch kann durch ein einfaches Einpressen der Regelelektronik 12 in eine entsprechende Halterung im Inneren des Gehäusedeckels 8 ein entsprechender Anpressdruck zwischen den abgewinkelten Enden der Kontaktanschlüssen der Reglerschaltung 12 und den in das Material des Gehäusedeckels 8 eingegossenen abgewinkelten Enden der Anschlusskontakte 5 erreicht werden, Hierzu ist eine Verlötung der entsprechenden Kontakte nicht erforderlich wobei trotzdem eine sichere Kontaktierung der korrespondierenden metallischen Leiter möglich wird.

Fig. 9 zeigt eine Darstellung einer Lüfterzarge 1 mit einem Reglermodul 2 auf der Lüfterzarge 1. In einem derartigen Ausführungsbeispiel der vorliegenden Erfindung kann der Verschlussflächen-Teilbereich der Abdeckplatte auch mit einer runden Wand ausgestattet sein, die von der Abdeckplatte (d.h. der Lüfterzarge 1) hervorsteht. Der Gehäusedeckel, der in Fig. 9 nicht dargestellt ist, kann beispielsweise auf die runde Wand aufgeschraubt oder ebenfalls durch Bajonettverschlüsse oder andere Kippverschlüsse an der Wand befestigt werden.

Fig. 10 zeigt eine weitere Darstellung des Ausführungsbeispiels der vorliegenden Erfindung mit einem Reglermodul 2 auf der Lüfterzarge 1. Aus Fig. 10 ist dabei ersichtlich, dass auch die Anschlüsse 5 in die Lüfterzarge 1 eingegossen werden können, so dass die Anschlüsse 5 durch das Material der Wand der Lüfterzarge 1 hindurch stehen. Auch kann wieder eine L-Form für die Anschlüsse 5 gewählt werden, so dass die Kontaktierung mit den Kontaktanschlüssen der Reglerschaltung 12 durch ein entsprechendes Einpressen der Reglerschaltung 12 in einen Innenbereich des Gehäuses möglich ist. Die Reglerschaltung 12 kann dabei wieder Leistungselektronik-Halbleiterbauelemente aufweisen, die thermisch an einen Kühlkörper 4 angebunden sind. Der Kühlkörper 4 kann nun in das Material der Lüfterzarge 1, insbesondere im Bereich des Verschlussflächen-Teilbereichs eingegossen sein, wie dies aus Fig. 11 ersichtlich ist. Hierbei können die Kühlzinken des Kühlkörpers 4 aus einer Rückseite der Lüfterzarge 1 herausragen. Die Lüfterzarge 1 kann ferner insbesondere im Verschlussflächer-Teilbereich eine Öffnung aufweisen, über die ein Mittelbereich des Kühlkörpers 4 thermisch gut kontaktierbar ist.

Die Fig. 11 zeigt eine rückwärtige Ansicht der Lüfterzarge 1 mit abstehenden Zinken des Kühlkörpers 4 und einer entsprechenden Öffnung im Mittelbereich des Kühlkörpers 4. Die Öffnung auf der rückwärtigen Seite der Lüfterzarge 1 dient dabei weniger einer guten Kontaktierungsmöglichkeit für Leistungselektronik-Halbleiterbauelemente als vielmehr einer guten Wärmeabfuhr auf die rückwärtige Seite der Lüfterzarge 1. Hierdurch kann eine Wärmeabfuhr über die Zinken des Kühlkörpers 4 nochmals verbessert werden.

In Fig. 12 zeigt eine Darstellung einer Ausführungsform des Kühlkörpers 4 als Stanzteil. Der Kühlkörper 4 sollte dabei aus Blech geformt oder gestanzt werden, um eine möglichst gute Wärmeübertragungsfähigkeit aufzuweisen. Der Kühlkörper 4 kann einen Mittelbereich aus in einem Blech aufweisen und am gegenüberliegenden Randbereichen je zwei versetzt angeordnete Reihen aus Zinken umfassen, über die eine Wärmeabgabe an eine die Zinken umgebende Luft einfach möglich ist. Ein derartiges Stanzteil kann dann als Kühlkörper 4 entweder in den Gehäusedeckel 8 gemäß dem zuvor beschriebenen Ausführungsbeispielen oder in die Lüfterzarge 1, insbesondere im Verschlussflächen-Teilbereich eingegossen werden um die beschriebenen Vorteile bei der Herstellung des integrierten Lüfterreglermoduls zu erzielen.

Fig. 13 zeigt ein Ablaufdiagramm eines Ausführungsbeispiels der vorliegenden Erfindung als Verfahren 20 zur Herstellung eines integrierten Lüfterreglermoduls, wobei das Verfahren 20 einen Schritt des Bereitstellens 22 einer Abdeckplatte für einen Lüfter eines Fahrzeugs aufweist, wobei ein Verschlussflächen-Teilbereich der Abdeckplatte als Verschlussfläche für einen Gehäusedeckel ausgestaltet ist und am Rand des Verschlussflächen-Teilbereichs zumindest eine Befestigungseinheit für einen Gehäusedeckel einer Reglereinheit vorgesehen ist. Ferner umfasst das Verfahren einen Schritt des Bereitstellens 24 eines Gehäusedeckels, der an der zumindest einen Befestigungseinheit der Abdeckplatte befestigbar ist. Schließlich umfasst das Verfahren einen Schritt des Aufsetzens 26 des Gehäusedeckels auf den Verschiussflächen-Teilbereich der Abdeckplatte und des Befestigens des Gehäusedeckels an dem Verschlussflächen-Teilbereich unter Verwendung der Befestigungseinheit, um ein die Reglereinheit umschließendes Gehäuse zu bilden.

## Patentansprüche

1. Integriertes Lüfterreglermodul (2), das folgende Merkmale aufweist:
- Abdeckplatte (1) für einen Lüften eines Fahrzeugs, wobei ein in der Ebene der Abdeckplatte (1) liegender Verschlussflächen-Teilbereich der Abdeckplatte (1) als Verschlussfläche für einen Gehäusedeckel (8) augestaltet ist und am Rand des Verschlussfläche-Teilbereich zumindest eine Befestigungseinheit (6) für den Gehäusedeckel (8) einer Reglereinheit (12) vorgesehen ist, und
- einen Gehäusedeckel (8), der an der zumindest einen Befestigungseinheit (6) der Abdeckplatte (1) befestigt ist, so dass der Verschlussfiächen-Teilbereich der Abdeckplatte (1) und der Gehäusedeckel (8) ein umschließendes Gehäuse für die Reglereinheit (12) bilden.

2. Integriertes Lüfterreglermodul (2) gemäß Anspruch 1, **dadurch gekennzeichnet, dass** der Verschlussflächen-Teilbereich eine runde Form aufweist und der Gehäusedeckel(8) ebenfalls eine runde Form aufweist, so dass das gebildete Gehäuse die Form eines Zylinders hat.

3. Integriertes Lüfterreglermodul (2) gemäß einem der vorhergehenden Anssprüche, **dadurch gekennzeichnet, dass** der Verschlussflächen-Teilbereich eine Aufnahmenut (7) zur Aufnahme einer Wand des Gehäusedeckels (8) aufweist.

4. Integriertes Lüfterreglermodul (2) gemäß einem der vorhergehenden Ansprüche, **dadurch gekennzeichnet, dass** der Gehäusedeckel (8) ferner einen Vorsprung (10) aufweist, der ausgebildet ist, um mit der Befestigungseinheit (6) als ein Bajonett-Verschluss zusammenzuwirken.

5. Integriertes Lüfterreglermodul (2) gemäß einem der vorhergehenden Ansprüche, **dadurch gekennzeichnet, dass** der Gehäusedeckel. (8) einen Kühlkörper (4) aufweist, der in den Gehäusedeckel (8) eingegossen oder eingespritzt ist

6. Integriertes Lüfterreglermodul (2) gemäß Anspruch 5, **dadurch gekennzeichnet, dass** der Gehäusedeckel (8) in einem Öffnungsbereich einen freiliegenden Teil des Kühlkörpers (4) aufweist, der zur thermischen Kontaktierung von zumindest einem Bauelement der Reglerschaltung (12) ausgebildet ist.

7. Integriertes Lüfterreglermodul (2) gemäß einem der vorhergehenden Ansprüche, **dadurch gekennzeichnet, dass** der Gehäusedeckel (8) Kontaktanschlüsse (5) zur Kontaktierung der Reglereinheit (12) von außerhalb des Gehäuses ausweist, wobei die Kontaktanschlüsse (5) in den Gehäusedeckel (8) eingegossen oder eingespritzt sind.

8. Integriertes Lüfterreglermodul (2) gemäß Anspruch 7, **dadurch gekennzeichnet, dass** die Kontaktanschlüsse (5) des Gehäusedeckels (8) in den Innenbereich des Gehäusedeckels (8) hineinragen und dort frei zugänglich sind, so dass eine Kontaktierung von freiliegenden Anschlusskontakten der Reglereinheit (12) durch nicht-stoffschlüssiges Verbinden, insbesondere Anpressen der Anschlusskontakte (5) an die Kontaktanschlüsse (5) durchführbar ist.

9. Integriertes Lüfterreglermodul (2) gemäß einem der vorhergehenden Ansprüche, **dadurch gekennzeichnet, dass** der Gehäusedeckel (8) einen Stecker (11) zur Aufnahme vor Steckkontakten aufweist, wobei der Stecker (11) einstückig mit dem Material des Gehäusedeckels (8) gefertigt ist.

10. Integriertes Lüfterreglermodul (2) gemäß einem der vorhergehenden Ansprüche, **dadurch gekennzeichnet, dass** die Abdeckplatte (1) im Verschlussflächen-Teilbereich einen Kühlkörper (4) aufweist, wobei der Kühlkörper (4) in die Abdeckplatte (1) eingegossen oder eingespritzt ist.

11. Integriertes Lüfterreglermodul (2) gemäß einem der vorhergehenden Ansprüche, **dadurch gekennzeichnet, dass** die Abdeckplatte (1) im Verschlussflächen-Teilbereich eine Wand aufweist, die von der Abdeckplatte (1) absteht, wobei die Wand ausgebildet ist, um den Gehäusedeckel (8) aufzunehmen und zusammen mit dem Gehäusedeckel (8) das die Reglereinheit (12) umschließende Gehäuse zu bilden.

12. Integriertes Lüfterreglermodul (2) gemäß einem der vorhergehenden Ansprüche, **dadurch gekennzeichnet, dass** die Abdeckplatte (1) im Verschlussflächen-Teilbereich Steckkontakte (5) aufweist, die derart ausgebildet sind, um eine Kontaktierung von Anschlusskontakten der Reglereinheit (12) von außerhalb des Gehäuses zu ermöglichen, wobei die Steckkontakte (5) in das Material der Abdeckplatte (1) eingegossen oder eingespritzt sind.

13. Integriertes Lüfterreglermodul (2) gemäß einem der vorhergehenden Ansprüche, **dadurch gekennzeichnet, dass** die Abdeckplatte (1) und/oder der Gehäusedeckel (8) aus einem Kunststoffmaterial sind.

14. Verfahren (20) zur Herstellung eines integrierten Lüfterreglermoduls (2), wobei das Verfahren (20) die folgenden Schritte umfasst:
- Bereitstellen (22) einer Abdeckplatte (1) für einen Lüfter eines Fahrzeugs, wobei ein in der Ebene der Abdeckplatte (1) liegender Derschlussflächen-Teilbereich der Abdeckplatte (1) als Verschlussfiäche für einen Gehäusedeckel (8) ausgestaltet ist und am Rand des Verschlussflächen-Teilbereichs zumindest eine Befestigungseinheit (6) für einen Gehäusedeckel (8) einer Reglereinheit (12) vorgesehen ist;
- Bereitstellen (24) eines Gehäusedeckels (8), der an der zumindest einen Befestigungseinheit (6) der Abdeckplatte (1) befestigbar ist; und
- Aufsetzen (26) des Gehäusedeckels (8) auf den Verschlussflächen-Teilbereich der Abdeckplatte (1) und Befestigen des Gehäusedeckels (8) an dem Verschlussflächen-Teilbereich unter Verwendung der Befestigungseinheit (6), um ein die Reglereinheit (12) umschließendes Gehäuse zu bilden.
